# EUROPÄISCHE PATENTANMELDUNG

(11) **EP 0 831 417 A2**
(43) Veröffentlichungstag der Anmeldung: **25.03.1998**
(21) Anmeldenummer: 97116490.0
(22) Anmeldetag: 22.09.1997
(51) Int. Cl.: G06K 7/10

(54) **Chipkarten-Kontaktiergerät**

(30) Priorität: 20.09.1996 DE 19638622
(71) Anmelder: AMPHENOL-TUCHEL ELECTRONICS GmbH, D-74080 Heilbronn (DE)
(72) Erfinder: Reichardt, Manfred, 74189 Weinsberg (DE)
(74) Vertreter: Wagner, Karl H., Dipl.-Ing.

(57) **Zusammenfassung**

Die vorliegende Erfindung sieht einen Rahmen für einen Chipkartenleser vor, bei dem Kontaktelemente vorgesehen sind, die zur Kontaktierung mit den Kontakten einer Chipkarte dienen, die in den Chipkartenleser in eine Lesestellung einführbar ist, wobei die Chipkarte in der Lesestellung mit ihren auf einer Seite der Karte getragenen Kontakten an den Kontaktelementen des Rahmens anliegt, während die andere Seite der Karte zur Aufnahme der Kontaktkraft durch eine Kontaktkraftaufnahmevorrichtung unterstützt ist,dadurch gekennzeichnet, daß die Kontaktkraftaufnahmevorrichtung für eine Linearberührung mit der Chipkarte ausgebildet ist.

## Beschreibung

Die Erfindung bezieht sich auf ein Chipkarten-Kontaktiergerät (Chipkartenleser), welches dazu dient, die Kontaktelemente eines Kontaktsatzes mit den Chipkartenkontakten in Berührung zu bringen, um so Information aus dem in der Chipkarte enthaltenen Chip auszulesen oder auch einzulesen.

Chipkartenleser werden in verschiedene Apparate oder dergleichen, beispielweise auch Telefonapparate, eingebaut, um so die Benutzung des Telefonapparats vom Einschieben einer geeigneten Chipkarte abhängig zu machen.

Chipkartenleser sind bereits in großer Anzahl bekannt und es sei in diesem Zusammenhang auf die deutsche Offenlegungsschrift 38 10 274 hingewiesen. Bei einer bekannten Bauart eines Chipkartenlesers, einer Bauart, die die vorliegende Erfindung insbesondere aber nicht ausschließlich weiterentwickelt, wird ein stationäres Bauteil (Rahmen) verwendet, wobei in diesem stationären Rahmen ein bewegliches Teil in der Form eines sogenannten Kontaktträgers hin- und herbeweglich angeordnet ist. Für die zwischen einer Ausgangsstellung und einer Lesestellung erfolgende Bewegung des Kontaktträgers sind entsprechende Führungsmittel vorgesehen. Wird eine Chipkarte in einen solchen Kartenleser eingesetzt, so muß auf die Chipkarte eine Schubkraft ("push") ausgeübt werden, um den Kontaktträger zur Lesestellung hin zu verschieben. In der Lesestellung wird der Kontaktträger zusammen mit der Chipkarte, deren Kontakte nunmehr kontaktiert werden, durch Brems- oder Haltemittel (Bremse) festgehalten, und zwar im allgemeinen entgegen der Kraft von Rückholfedern, die bestrebt sind, den Kontaktträger in seine Ausgangsstellung zurückzubringen. Wenn man die Karte nach dem Lesevorgang wieder entnehmen möchte, so muß man an dem im allgemeinen aus dem Chipkartenleser noch herausragenden Ende der Karte ziehen ("pull"), um so die Karte und den Kontaktträger gegenüber der Bremse freizusetzen. Bei diesem Herausziehen der Chipkarte läuft dann auch der Kontaktträger wieder in seine Ausgangsstellung, im allgemeinen unter Einwirkung der erwähnten Rückholfedermittel zurück. Ein Chipkartenleser dieser Bauart wird auch nach dem Push-Pull-Prinzip arbeitend bezeichnet.

Die bekannten Chipkartenleser, insbesondere auch der Push/Pull Chipkartenleser gemäß DE 38 10 274.1 oder auch sogenannte Einfachleser, bei denen kein beweglicher Kontaktträger verwendet wird, sondern die Kontaktelemente direkt in einem Rahmen angeordnet oder eingespritzt sind, verwenden ein eine Kartenauflage bildendes Unterteil, welches an einem Oberteil z. B dem Rahmen befestigbar ist. Da das Unterteil an sich nicht benötigt wird, kann es beispielweise seitens des Apparates, in dem der Chipkartenleser verwendet wird, vorgesehen sein, wobei dieses dann die Kartenauflage vorsieht.

Die Verwendung einer Kartenauflage in der Form eines Unterteils des Chípkartenlesers oder auch als Teil eines Apparats, in dem der Chipkartenleser verwendet wird, hat den Nachteil, daß in den Chipkartenleser eindringende oder auch absichtlich eingeführte Fremdkörper wie beispielsweise nur Teile einer Chipkarte (z. B. eine halbe Chipkarte) den gesamten Leser blockieren. Solcher Vandalismus kann das Gerät, in dem der Chipkartenleser verwendet wird, unbenutzbar machen.

Zur Vermeidung dieses Nachteils sieht die Erfindung vor, daß die Rolle der Auflagefläche gemäß dem Stand der Technik durch eine Linienberührung für die Chipkarte übernommen wird. Diese Linienberührung wird vorzugsweise durch mindestens einen Bolzen, eine Stange oder eine Welle vorgesehen.

Eine solche Stange bildet eine Linien-Auflage für die Chipkarte, insbesondere die in der Leseposition befindliche Chipkarte, und erstreckt sich über die Unterseite des Rahmens und zwar mit einem Abstand, der den Durchtritt der Chipkarte ermöglicht. Die Stange bildet so eine Kontaktkraftabstützung. Gleichzeitig wird durch die Linienberührung ein Freiraum für den Durchtritt von Kontaktteilen oder anderen Fremdkörpern geschaffen

Die Stange erstreckt sich insbesondere auch im Falle eines Lesers gemäß DE 38 10 274.1 vorzugsweise über den Bereich der Unterseite des Rahmens, wo eine den beweglichen Kontaktträger aufnehmende Öffnung vorgesehen ist.

Gemäß einem bevorzugten Ausführungsbeispiel ist die Stange an ihren beiden Enden am Rahmen befestigt. Gemäß einer weiteren Ausgestaltung der Erfindung ist die Stange ein runder Bolzen. Der runde Bolzen bzw. die Stange sind vorzugsweise im Bereich der Lesekontakte, wenn diese sich in der Leseposition (aktive Position) befinden, angeordnet.

Gemäß einer bevorzugten Ausgestaltung ist auf dem runden Bolzen eine Elastomerrolle drehbar gelagert.

Gemäß einer weiteren bevorzugten Ausgestaltung der Erfindung ist die runde Stange drehbar an ihren beiden Enden in Lagerteilen gelagert, die ihrerseits vorzugsweise am Rahmen oder apparateseitig befestigt sind.

Eine rohrförmige Elastomerschicht ist vorzugsweise auf der Stange vorgesehen, vorzugsweise darauf aufgespritzt. Die Elastomerschicht ist vorzugsweise lediglich in der Mitte der Stange bzw. dem Bolzen bzw. der Welle in etwa im Bereich einer Öffnung im Rahmen vorgesehen. Vorzugsweise kann die Elastomerschicht auch dadurch gebildet werden, daß man einen Elastomerschlauch auf die Stange aufschiebt. Der Schlauch kann entweder auf der Stange durch Eigenelastizität festsitzen oder auch aufgeklebt sein.

Zur Lösung der Aufgabe sieht die Erfindung einen Chipkartenleser insbesondere gemäß dem Oberbegriff des Anspruchs 1 vor, der durch die im kennzeichnenden Teil dieses Anspruchs angegebenen Merkmale gekennzeichnet ist. Bevorzugte Ausgestaltungen ergeben sich aus den Unteransprüchen.

Weitere Vorteile, Ziele und Einzelheiten der Erfindung ergeben sich aus der Beschreibung von Ausführungsbeispielen anhand der Zeichnung; in der Zeichnung zeigt:
- Fig. 1: schematisch einen Chipkartenleser mit Chipkarte sowie einen Apparat, beispielsweise einen Telefonapparat, in den der Chipkartenleser eingebaut werden kann;
- Fig. 2: eine Draufsicht auf einen Chipkartenleser gemäß dem Stand der Technik mit in Lesestellung befindlicher Chipkarte;
- Fig. 3: einen Schnitt längs der Linie 4-4 in Fig. 2, wobei aber im Gegensatz zur Fig. 2 die Chipkarte sowie ein durch die Chipkarte bewegter Kontaktträger sich in ihrer Ausgangsstellung befinden;
- Fig. 4: einen Schnitt längs der Linie 4-4 in Fig. 2 mit Chipkarte und zugehörigem Kontaktträger in Lesestellung, wobei hier auch dargestellt ist, daß das Lesegerät aus einem Oberteil, dem sogenannten Rahmen, und einem Unterteil bestehen kann;
- Fig. 5: eine Draufsicht auf den Rahmen des Chipkartenlesers gemäß Fig. 2 bei nichteingesetztem Kontaktträger;
- Fig. 6: einen Schnitt längs der Linie 6-6 in Fig. 5, wobei schematisch noch Führungsmittel des Kontaktträgers dargestellt sind;
- Fig. 7: eine Ansicht des in Fig. 5 gezeigten Rahmens von unten, d. h. auf die Unterseite des Rahmens;
- Fig. 8: eine Draufsicht auf die Unterseite des Rahmens eines ersten Ausführungsbeispiels eines erfindungsgemäßen Chipkartenlesers bei entferntem Kontaktträger;
- Fig. 9: eine Seitenansicht des Rahmens gemäß Fig. 8;
- Fig. 10: eine Einzelheit des in Fig. 8 nicht aber in Fig. 2 gezeigten Kontaktträgers zur Darstellung einer bevorzugten Positionierung einer in Fig. 8 gezeigten Stange;
- Fig. 11: einen schematischen Teilschnitt längs der Linie 16-16 in Fig. 10;
- Fig. 12: schematisch ein zweites Ausführungsbeispiel eines erfindungsgemäßen Chipkartenleser, wobei hier anders als in Fig. 8 eine pespektivische Draufsicht auf die Oberseite des Rahmens dargestellt ist;
- Fig. 13: eine schematische Vorderansicht des Chipkartenlesers gemäß Fig. 12;
- Fig. 14: ein drittes Ausführungsbeispiel der Erfindung ähnlich Fig. 13, wobei hier die Halterung einer Stange am Rahmen dargestellt ist;
- Fig. 15: ein viertes Ausführungsbeispiel der Erfindung ähnlich Fig. 13, wobei hier die Halterung einer Stange an einem Apparat dargestellt ist, mit dem der Chipkartenleser verwendet werden soll;
- Fig. 16: eine schematische Draufsicht auf die Unterseite des Rahmens der Fig. 12, wobei hier zusätzlich noch die Möglichkeit dargestellt ist, daß nicht nur eine Stange wie in Fig. 12 sondern eine weitere Stange vorgesehen ist.
- Fig. 17: eine Ansicht ähnlich Fig. 16, wobei eine andere Anordnung der beiden Stangen oder Wellen dargestellt ist.

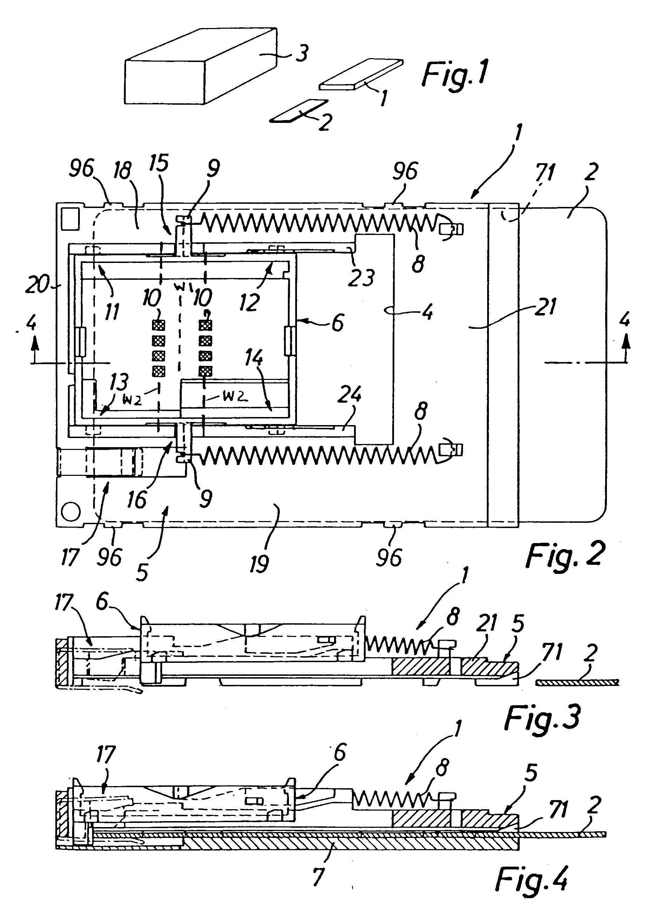

In Fig. 1 ist mit dem Bezugszeichen 3 schematisch irgend ein Apparat, beispielsweise ein Telefonapparat bezeichnet, in welchen ein Chipkartenleser (Chipkarten-Kontaktiergerät) 1 gemäß der Erfindung eingebaut werden kann. Eine Chipkarte 2 dient nach dem Einbau des Chipkartenlesers 1 in den Apparat 3 dazu, den Apparat 3 beispielsweise betriebsbereit zu machen, indem ein Benutzer die Chipkarte 2 in den Chipkartenleser 1 einschiebt.

### STAND DER TECHNIK

In den Fig. 2 bis 7 ist ein aus DE 38 10 274 A1 bekannter Chipkartenleser 1 im einzelnen dargestellt.

Hinsichtlich des Aufbaus des Chipkartenlesers 1 sei nunmehr in erster Linie auf die Fig. 2 bis 7 Bezug genommen. Speziell in Fig. 2 und 4 erkennt man, daß der Chipkartenleser 1 ein stationäres Bauteil 5 aufweist, welches auch als Oberteil oder Rahmen bezeichnet werden kann. Als Oberteil kann dieser Rahmen deshalb bezeichnet werden, weil an diesem ein in Fig. 4 im Schnitt dargestelltes eine Kartenauflage bildendes Unterteil 7 befestigbart ist, wobei allerdings sämtliche Funktionen des Chipkartenlesers 1 im Oberteil oder Rahmen 5 realisiert werden, so daß das Unterteil 7 an sich nicht benötigt wird, sondern beispielsweise seitens des Apparats 3 vorgesehen ist, welches dann die Kartenauflage vorsieht.

Der Rahmen 5 bildet eine Öffnung 4, die durch zwei Rahmenseitenteile 18, 19 sowie ein Rahmenrückteil 20 und Rahmenvorderteil 21 begrenzt ist.

Im Bereich der Öffnung 4 ist ein einen nicht gezeigten Kontaktsatz tragender Kontaktträger 6 hin- und herbeweglich zwischen einer in Fig. 3 gezeigten Ausgangsstellung und einer in den Fig. 2 und 4 gezeigten Lesestellung bewegbar. Rückholmittel 8 in der Form von zwei Schraubenfedern sind bestrebt, den Kontaktträger 6 in seiner Ausgangsstellung zu halten.

In Fig. 2 sieht man die auf der Chipkarte 2 vorhandenen Chipkartenkontakte 10. Dies liegt daran, daß im dargestellten Ausführungsbeispiel der Kontaktträger 6 seinerseits rahmenförmig ausgebildet ist, aber ein die Kontaktelemente des Kontaktträgers 6 tragendes Bauteil (Kontaktsatz) nicht in den Kontaktträger 6 eingesetzt ist.

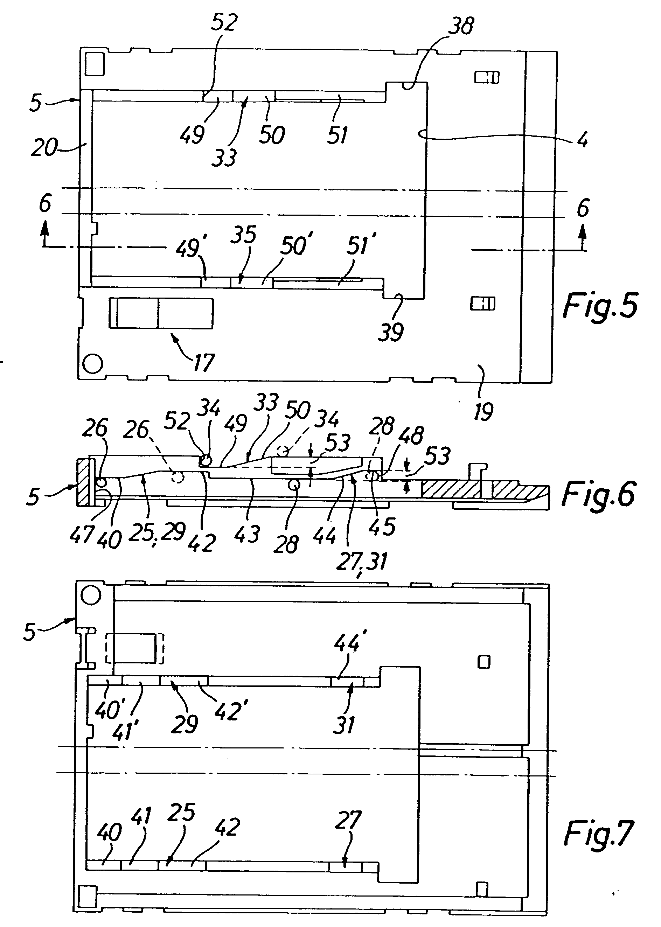

Die Lagerung und formschlüssige Führung des Kontaktträgers 6 am Rahmen 5 erfolgt durch Führungsmittel, und zwar speziell durch erste bis sechste Führungsmittel 11 bis 16. Die Führungsmittel ermöglichen eine formschlüssige Absenkung des den Kontaktsatz tragenden Kontaktträgers 6, bei dessen Bewegung aus seiner (in Fig. 6 durch drei gestrichelt angedeutete Zapfen 26, 28, 34 repräsentierten) Ausgangsstellung (Fig. 3) in die (in Fig. 6 durch drei mit ausgezogenen Linien dargestellte Zapfen 26, 28 34 repräsentierten) Lesestellung.

Im einzelnen sieht das dargestellte Ausführungsbeispiel, vgl. dazu die Fig. 5, 6 und 7, folgendes vor:
Die ersten Führungsmittel 11 bestehen aus einer ersten rahmenseitigen Führung in der Form einer ersten Führungsbahn 25 und einer ersten kontaktträgerseitigen Führung in der Form eines ersten Führungszapfens 26. Die zweiten Führungsmittel 12 weisen zweite rahmenseitige Führungsmittel in der Form einer zweiten Führungsbahn 27 sowie eine zweite kontaktträgerseitige Führung in der Form eines zweiten Zapfens 28 auf. Die dritten Führungsmittel 13 weisen eine dritte rahmenseitige Führung in der Form einer dritten Führungsbahn 29 sowie eine dritte kontaktträgerseitige Führung in der Form eines dritten Zapfens auf. Die vierten Führungsmittel umfassen eine vierte rahmenseitige Führung in der Form einer vierten Führungsbahn 31 sowie eine vierte kontaktträgerseitige Führung in der Form eines vierten Zapfens. Die fünften Führungsmittel 15 weisen eine fünfte rahmenförmige Führung in der Form einer fünften Führungsbahn 33 sowie eine fünfte kontaktträgerseitige Führung in der Form eines fünften Zapfens 34 auf. Die sechsten Führungsmittel 16 schließlich weisen eine sechste rahmenseitige Führung in der Form einer sechsten Führungsbahn sowie eine sechste kontaktträgerseitige Führung in der Form eines sechsten Zapfens auf.

Die rahmenseitigen Führungen sind vorzugsweise an Längsstegen 23 und 24 ausgebildet, die vo den Rahmenseitenteilen 18, 19 nach innen ragen. Die Stege 23, 24 erstrecken sich nicht über die ganze Länge der Öffnung 4, sondern bilden, wie beispielsweise in Fig. 5 gezeigt, eine Montageöffnung 38 bzw. 39.

Die erste Führungsbahn 25 umfaßt eine ebene Führungsbahn 40 mit daran anschließender schräger Führungsbahn (Absenk- bzw. Andrückkurve) 41 und eine weitere höhenmäßig (um die Größe 53 in Fig. 6) gegenüber der Führungsbahn 40 versetzte ebene Führungsbahn 42. Ähnlich weist auch die zwiete Führungsbahn 27 eine ebene Führungsbahn 43 mit daran anschließender schräger Führungsbahn (Absenk- bzw. Andrückkurve) 44 sowie an diese anschließender ebener Führungsbahn 45 auf, welchletztere wiederum höhenmäßig (um die Größe 53 in Fig. 6) gegenüber der Führungsbahn 43 versetzt ist. Ferner werden für die Führungszapfen 26 und 28 Anschläge 47 gebildet.

Die fünfte Führungsbahn 33 weist eine ebene Führungsbahn 49, daran anschließend eine schräge Führungsbahn 50 und wiederum an diese anschließend eine höhenmäßig gegenüber der Bahn 49 versetzte ebene Führungsbahn 51 auf. Ferner wird ein Anschlag 52 für den fünften Zapfen 34 gebildet, wenn sich der Kontaktträger 6 in seiner Lesestellung befindet.

Wegen des symmetrischen Aufbaus, d. h. die ersten Führungsmittel 11 ensprechen den dritten Führungsmitteln 13, die zweiten Führungsmittel 12 entsprechen den vierten Führungsmitteln 14 und die fünften Führungsmittel 15 entsprechen den sechsten Führungsmitteln 16, werden im folgenden, wenn notwendig, für Einzelheiten der Führungsmittel 13, 14 und 16 die gleichen Bezugszeichen wie für die Führungsmittel 11, 12 und 15, jedoch mit eine Strich versehen, verwendet.

Der Kontaktträger 6 und der nicht gezeigte Kontaktsatz können als ein Stück aus Kunststoff hergestellt sein. Auch der Rahmen 5 ist vorzugsweise auf Kunststoff, und zwar insbesondere durch Spritzguß hergestellt.

Der gezeigte Chipkartenleser arbeitet nach dem sogenannten Push-Pull-Prinzip, d. h. nach dem Einschieben (push) der Karte 2 bis in die Lesestellung wird diese dort von einer Bremse 17 gehalten und kann aus dieser nach Beendigung des Lesevorgangs wieder herausgezogen (pull) werden.

### ERSTES AUSFÜHRUNGSBEISPIEL

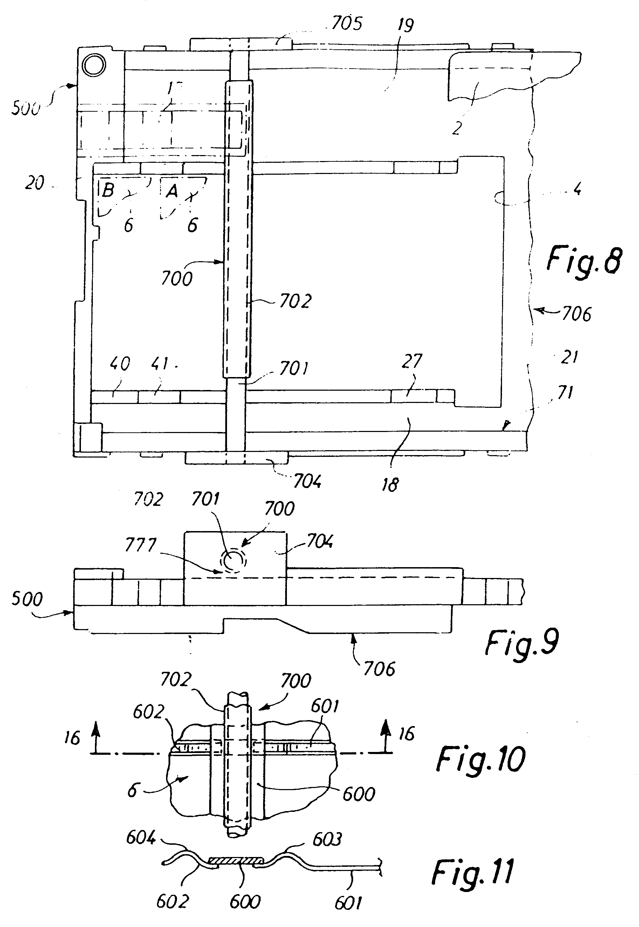

Die Fig. 8 bis 11 zeigen ein erstes Ausführungsbeispiel eines gemäß der Erfindung ausgebildeten Rahmens 500, der in einem Chipkartenleser verwendet werden kann, ohne daß dabei wie beim oben beschriebenen Stand der Technik eine Kartenauflage durch ein Unterteil oder durch einen den Chipkartenleser aufnehmenden Apparat gebildet wird.

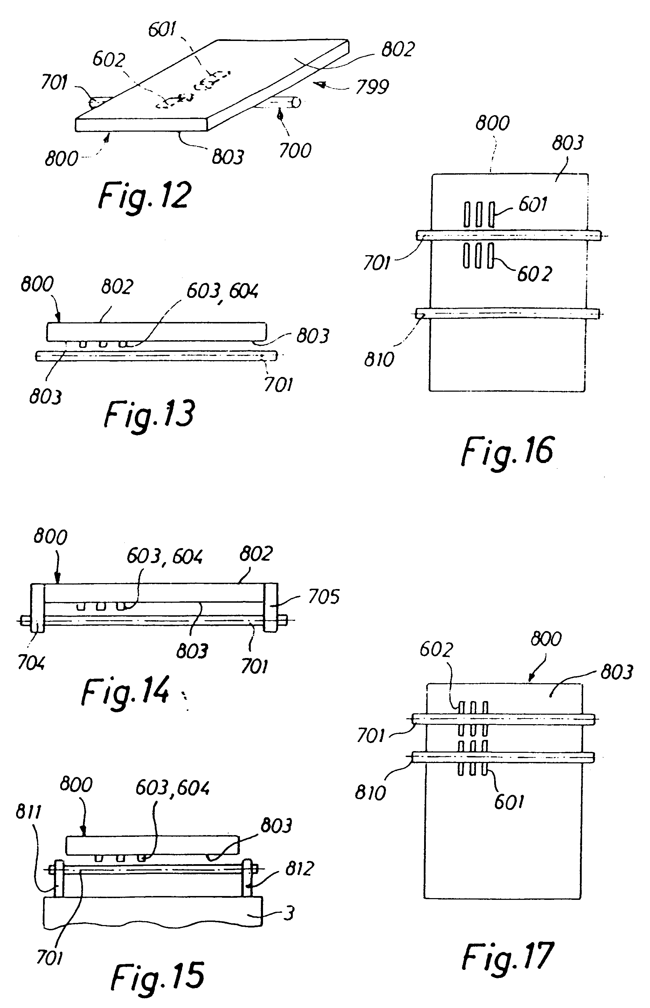

Der erfindungsgemäße Rahmen 500 ist praktisch identisch zum Rahmen 5 des oben beschriebenen Standes der Technik ausgebildet. Insbesondere entspricht die Fig. 8 (die eine Draufsicht auf die Rahmenunterseite 706 ist) mit Ausnahme der neu hinzugekommenen und noch zu beschreibenden Kartenauflage oder Kontaktkraftabstützung 700 der Fig. 7, die die Unterseite des Rahmens 5 zeigt. Anders als der Stand der Technik gemäß Fig. 2 bis 7 benötigt der erfindungsgemäße Rahmen 500 auch nicht die nur noch schematisch in Fig. 8 gezeigten Bremsmittel 17, da die Kontaktkraftabstützung 700 die Funktion der Bremse übernimmt. Im Rahmen 500 ist ein in Fig. 8 nicht (aber in Fig. 10 teilweise) gezeigter Kontaktträger 6 gelagert, der mit dem Kontaktträger 6 des oben beschriebenen Standes der Technik identisch ist. Wenn der Kontaktträger 6 mit seinem Kontaktsatz im Rahmen 500 eingesetzt wäre, so würden seine Kontaktelemente in Fig. 8 in Draufsicht zu sehen sein. Eine Einzelheit dieses Kontaktträgers 6 wird weiter unten anhand der Fig. 10 und 11 dargestellt, und zwar zusammen mit einer bevorzugten Positionierung der erfindungsgemäßen Kontaktkraftabstützung (Kontaktkraftabstützmittel; Kontaktabstützvorrichtung) 700.

Allgemein sieht die Erfindung vor, daß die erfindungsgemäßen Kontaktkraftabstützung 700 derart ausgebildet und über die Rahmenunterseite 706 hinweg verlaufend vorgesehen ist, daß eine durchgängige flächige Kontaktkraftabstützung für die Chipkarte 2, sei es durch ein Unterteil oder den Apparat selbst vermieden wird. Erfindungsgemäß ist die Kontaktkraftabstützung 700 so ausgebildet, daß eine nur linienförmige Abstützung für die Chipkarte 6 vorgesehen wird.

Vorzugsweise ist (vgl. Fig. 10 und 11) die Kontaktkraftabstützung 700 im Bereich der Lesekontakte 601, 602 (aktive Position) oder zwischen diesen Kontaktelementen und der Einstecköffnung 71 angeordnet. Es sei hier daran erinnert, daß der Kontaktträger 6 beim Einschieben der in Fig. 13 nur teilweise angedeuteten Chipkarte 2 aus der in Fig. 13 mit "A" in die mit "B" bezeichnete Position (unter Absenkung des Kontaktträgers 6) verschoben wird.

Wie im ersten Ausführungsbeispiel der Erfindung gemäß den Fig. 8 und 9 gezeigt, wird die Kontaktkraftabstützung 700 durch eine Stange (auch als Welle oder Bolzen bezeichnet) 701 gebildet. Die Welle 701 ist vorzugsweise rund und ist mit einer Elastomerschicht 702 versehen. Die Elastomerschicht 702 kann auf die Welle 701 aufgespritzt sein. Alternativ kann ein aus Elastomermaterial bestehender die Schicht 702 bildender Schlauch auf die Welle 701 aufgeschoben sein. Der Schlauch kann durch seine Eigenelastizität fest auf dem Bolzen sitzen. Gegebenenfalls kann der Schlauch an der Welle 701 befestigt beispielsweise angeklebt sein.

Die Breite der Elastomerschicht 702 oder des die Schicht bildenden Schlauchs kann unterschiedlich gewählt sein. Vorzugsweise ist die Elastomerschicht 702 im Bereich der Breite des Kontaktträgers 6 vorgesehen. Die Elastomerschicht 702 kann sich aber auch über die gesamte Breite des Rahmens 500 bzw. der Chipkarte 2 erstrecken.

Es ist auch denkbar, anstelle des Leserbodens den zur Kontaktkraftabstützung dienenden runden Welle mit einer darauf drehbar gelagerten Elastomerrolle vorzusehen.

Im ersten Ausführungsbeispiel der Fig. 8 und 9 ist die Welle 701 am Rahmen 500 befestigt, vorzugsweise drehbar gelagert. Zur Anbringung dienen an den Seitenteilen 18, 19 des Rahmens 500 angebrachte Lagerplatten 704, 705 mit Bohrungen in denen sich die Welle 701 drehen kann.

Vorzugsweise ist die Welle 701 wie gezeigt quer über die Breite des Rahmens 500 verlaufend vorgesehen. Die Welle 701 bildet zusammen mit der Schicht 702 einen Spalt 777 (Fig. 9) derart, daß eine Chipkarte 2 zwischen Rahmen-Kartenauflagefläche und Schicht 702 eingeschoben werden kann. Wenn die Karte 2 eingeschoben ist und der Kontaktträger 6 sich in der Lesestellung (mit B in Fig. 8 angedeutet) befindet, nimmt die Welle 701 die Kontaktkraft auf und legt oder klemmt die Karte 2 fest, so daß vorzugsweise keine zusätzliche bei 17 angedeutete Kartenbremse erforderlich ist.

Die bevorzugte in Fig. 8 und 9 gezeigte Positionierung des Bolzens 701 wird in Fig. 10 und 11 verdeutlicht.

Die Fig. 10 und 11 zeigen einen Ausschnitt des Kontaktträgers 6, der im einzelnen auch in den Fig. 2, 3 und 4 dargestellt ist. Allerdings sind in diesen genannten Figuren die in Fig. 10 und 11 gezeigten Kontaktelemente 601, 602 (die auch als Lesekontakte bezeichnet werden) nicht gezeigt. Bekanntlich sind mindestens vier solcher Lese-Kontaktelementpaare 601, 602 nebeneinander und gegenüberliegend im Kontaktträger 6 angeordnet. Die eingesetzte Chipkarte 2 kann dann mit ihren in Fig. 2 gezeigten Chipkartenkontakten 10 Kontakt mit den Lesekontakten 601, 602 herstellen. Üblicherweise sind im Kontaktträger 6 auch noch Schaltkontakte vorgesehen.

Der Kontaktträger 6 selbst ist üblicherweise aus Kunststoff hergestellt, und die Kontaktelemente 601, 602 usw. sind entweder im Kunststoff eingespritzt oder in in dem Kunststoff des Kontaktträgers 6 ausgebildete Kammern eingesetzt.

Bei einem bevorzugten Ausführungsbeispiel des Kontaktträgers 6 wird von diesem (vgl. Fig. 10 und 11) ein Steg 600 gebildet, an dem die freien Enden der Kontaktelemente 601, 602 usw. vorzugsweise unter Vorspannung anliegen. In Fig. 10 ist nur ein Kontaktelementpaar 601, 602 dargestellt, es sind aber z. B. noch drei weitere solcher Paare vorzustellen. Beim Einschieben der Chipkarte in den Spalt 777 zwischen der Unterseite 706 des Rahmens 500 und der Kontaktkraftabstützung 700 werden die vorzugsweise Kuppen 603, 604 aufweisenden Kontaktelemente 601, 602 (in Fig. 11) nach unten gedrückt. Dadurch, daß man vorzugsweise die Kontaktkraftabstützung 700 (speziell die Welle 701) im Bereich des Stegs 600 anordnet, erzielt man eine günstige Abstützung der Kontaktkraft wenn sich der Kontaktträger 6 in der mit B in Fig. 8 bezeichneten Leseposition (aktiver Bereich) befindet.

### ZWEITES AUSFÜHRUNGSBEISPIEL

Die Erfindung wurde zusammen mit einem Chipkartenleser beschrieben, der einen absenkbaren Kontaktsatz 6 aufweist. Die Erfindung ist in gleicher Weise bei einem Chipkartenleser verwendbar, der keinen absenkbaren Kontaktsatz verwendet. Ein solcher Chipkartenleser 799 ist als zweites Ausführungsbeispiel der Erfindung schematisch in Fig. 12 und 13 dargestellt. Der Chipkartenleser 799 besitzt einen (im Vergleich mit Fig. 8 und 9 umgedreht dargestellten) Kunststoffrahmen 800 mit einer Oberseite 802 und einer Unterseite 803. In dem vorzugsweise aus Kunststoff gespritzten Rahmen 801 sind schematisch gezeigte Kontaktelemente 601, 602 usw. angeordnet, die mit ihren vorzugsweise vorhandenen Kontaktkuppen 603, 604 von der Unterseite 803 des Rahmens 801 vorzugsweise wegragen, wie dies in Fig. 13 dargestellt ist. Es ist hier also kein beweglicher Kontaktträger 6 vorgesehen.

Auch für einen solchen Chipkartenleser 799 der sogenannten Einfach-Bauart ist die erfindungsgemäßen Kontaktkraftabstützung (Kontaktkraftaufnahmemittel) 700 zweckmäßig. Im Ausführungsbeispiel der Fig. 12 und 13 ist die Kontaktkraftabstützung 700 durch einen Bolzen (Stange oder eine Welle) 701 realisiert, die wie im oberen Teil der Fig. 16 gezeigt quer über den Rahmen 800 hinweg verläuft. Statt nur eine Welle 701 zu verwenden, können auch mehrere beispielsweise zwei solcher Bolzen verwendet werden. Die Draufsicht der Fig. 16 auf die Unterseite 803 des Rahmens 800 zeigt die Möglichkeit der Anordnung von mehr als nur einer Welle 701 quer verlaufend über die Unterseite 803. In Fig. 16 ist mit Abstand gegenüber der Welle 701 eine weitere Welle 810 dargestellt. Im zweiten Ausführungsbeispiel gemäß Fig. 12 und 13 ist offengelassen, wo die Kontaktkraftabstützung 700 in der Form einer Welle 700 angeordnet ist. Sei es am Rahmen 800 ähnlich wie für das erste Ausführungsbeispiel gezeigt oder sei es an dem Apparat 3, bei dem der Chipkartenleser eingesetzt wird.

### DRITTES AUSFÜHRUNGSBEISPIEL

Im dritten Ausführungsbeispiel gemäß Fig. 14 ist dargestellt, daß die Welle 701 ähnlich wie beim ersten Ausführungsbeispiel gemäß Fig. 8 durch Tragarme 704, 705 am Rahmen 800 befestigt ist. Die Welle 701 kann in den Tragarmen 704, 705 beispielsweise durch Gleitlagerung drehbar gelagert sein. Die Welle 701 kann aber auch fest an dem Tragrahmen angebracht sein. Die Welle 701 der beiden Ausführungsbeispiele kann beliebige Gestalt besitzen, sie ist vorzugsweise im Querschnitt kreisförmig.

### WEITERE AUSFÜHRUNGSBEISPIELE

Das Ausführungsbeispiel der Fig. 15 veranschaulicht eine andere Anordnung der Kontaktkraftaufnahmemittel 700 bzw. der Welle bzw. der Welle 701. Hier ist die Welle 701 durch Lagerarme 811, 812 am Apparat 3 beispielsweise einem Telefonapparat angeordnet. Auch bei dem Ausführungsbeispiel gemäß Fig. 15 können statt nur einer Welle 701 auch zwei oder mehrere vorgesehen werden so wie es beispielsweise schematisch in Fig. 16 gezeigt ist.

Fig. 17 zeigt eine gegenüber Fig. 16 alternative Lage für die Bolzen (Wellen) 701 und 810. Die Wellen 701 und 810 liegen im wesentlichen im Bereich der Kontaktelemente 601, 602 und zwar insbesondere im Bereich von Kontaktkuppen dieser Kontaktelemente 601, 602. Die bevorzugte Lage bei Verwendung einer einzigen Welle 701 ist in Fig. 2 durch die mit W1 bezeichnete gestrichelte Linie angedeutet. Die Linien W2 in Fig. 2 zeigen die gegenüber Fig. 16 alternative Anordnung von zwei Wellen 701, 810.

Es sei bemerkt, daß die Ziele und Vorteile der Erfindung erreicht werden können durch jegliche Verbesserungen, Veränderungen und Modifikationen, die durch die nachfolgende Zusammenfassung der Erfindung und die Ansprüche abgedeckt werden.

### Zusammenfassung der Erfindung:

1. Rahmen für einen Chipkartenleser, bei dem Kontaktelemente vorgesehen sind, die zur Kontaktierung mit den Kontakten einer Chipkarte dienen, die in den Chipkartenleser in eine Lesestellung einführbar ist,
   wobei die Chipkarte in der Lesestellung mit ihren auf einer Seite der Karte getragenen Kontakten an den Kontaktelementen des Rahmens anliegt, während die andere Seite der Karte zur Aufnahme der Kontaktkraft durch eine Kontaktkraftaufnahmevorrichtung unterstützt ist,
   dadurch gekennzeichnet, daß
   die Kontaktkraftaufnahmevorrichtung für eine Linearberührung mit der Chipkarte ausgebildet ist.
2. Rahmen , dadurch gekennzeichnet, daß die Linearberührung durch die Kontaktkraftaufnahmevorrichtung in Bereichen außerhalb der Linearberührung nicht existent ist.
3. Rahmen , dadurch gekennzeichnet, daß die Kontaktkraftaufnahmevorrichtung durch ein langgestrecktes Bauteil gebildet ist.
4. Rahmen , dadurch gekennzeichnet, daß das langgestreckte Bauteil beispielsweise eine Stange, eine Welle oder ein Stift ist.
5. Rahmen , dadurch gekennzeichnet, daß mehrere vorzugsweise beabstandete langgestreckte Bauelemente die Kontaktkraftabstützvorrichtung bilden.
6. Rahmen , dadurch gekennzeichnet, daß die langgestreckten Kontaktkraftabstützmittel am Rahmen angebracht sind.
7. Rahmen , dadurch gekennzeichnet, daß die langgestreckten Kontaktkraftabstützmittel an dem Apparat angebracht sind, welches den Chipkartenleser verwendet.
8. Rahmen , dadurch gekennzeichnet, daß die langgestreckte Kontaktkraftaufnahmevorrichtung sich quer zur Einsteckrichtung der Karte erstreckt.
9. Rahmen , dadurch gekennzeichnet, daß die langgestreckte Kontaktkraftaufnahmevorrichtung an ihren beiden Enden drehbar gelagert ist.
10. Rahmen , dadurch gekennzeichnet, daß auf der langgestreckten Kontaktkraftaufnahmevorrichtung ein Elastomermaterial insbesondere im Bereich der Karte aufgebracht ist.
11. Rahmen , dadurch gekennzeichnet, daß der Spalt zwischen der Unterseite des Rahmens und der Kontaktkraftaufnahmevorrichtung derart vorgesehen ist, daß die Chipkarte in der Leseposition sicher gehalten ist.
12. Rahmen , dadurch gekennzeichnet, daß im Bereich der Lesekontakte und/oder zwischen dem Lesekontakten und der Einstecköffnung des Chipkartenlesers ein runder Bolzen angeordnet ist, auf dem eine Elastomerrolle drehbar gelagert ist.
13. Rahmen , dadurch gekennzeichnet, daß die durch die Kontaktaufnahmevorrichtung auf die Karte ausgeübte Kraft ausreicht, die Karte in der aktiven oder Leseposition verschleißfrei festzuhalten.

## Patentansprüche

1. Rahmen für einen Chipkartenleser, bei dem Kontaktelemente vorgesehen sind, die zur Kontaktierung mit den Kontakten einer Chipkarte dienen, die in den Chipkartenleser in eine Lesestellung einführbar ist,
wobei die Chipkarte in der Lesestellung mit ihren auf einer Seite der Karte getragenen Kontakten an den Kontaktelementen des Rahmens anliegt, während die andere Seite der Karte zur Aufnahme der Kontaktkraft durch eine Kontaktkraftaufnahmevorrichtung unterstützt ist,
dadurch gekennzeichnet, daß
die Kontaktkraftaufnahmevorrichtung für eine Linearberührung mit der Chipkarte ausgebildet ist.

2. Rahmen nach Anspruch 1, dadurch gekennzeichnet, daß die Linearberührung durch die Kontaktkraftaufnahmevorrichtung in Bereichen außerhalb der Linearberührung nicht existent ist.

3. Rahmen nach Anspruch 1, dadurch gekennzeichnet, daß die Kontaktkraftaufnahmevorrichtung durch ein langgestrecktes Bauteil gebildet ist.

4. Rahmen nach Anspruch 1, dadurch gekennzeichnet, daß das langgestreckte Bauteil beispielsweise eine Stange, eine Welle oder ein Stift ist.

5. Rahmen nach Anspruch 1, dadurch gekennzeichnet, daß mehrere vorzugsweise beabstandete langgestreckte Bauelemente die Kontaktkraftabstützvorrichtung bilden.

6. Rahmen nach Anspruch 1, dadurch gekennzeichnet, daß die langgestreckten Kontaktkraftabstützmittel am Rahmen angebracht sind.

7. Rahmen nach Anspruch 1, dadurch gekennzeichnet, daß die langgestreckten Kontaktkraftabstützmittel an dem Apparat angebracht sind, welches den Chipkartenleser verwendet.

8. Rahmen nach Anspruch 1, dadurch gekennzeichnet, daß die langgestreckte Kontaktkraftaufnahmevorrichtung sich quer zur Einsteckrichtung der Karte erstreckt.

9. Rahmen nach Anspruch 1, dadurch gekennzeichnet, daß die langgestreckte Kontaktkraftaufnahmevorrichtung an ihren beiden Enden drehbar gelagert ist.

10. Rahmen nach Anspruch 1, dadurch gekennzeichnet, daß auf der langgestreckten Kontaktkraftaufnahmevorrichtung ein Elastomermaterial insbesondere im Bereich der Karte aufgebracht ist, und/oder wobei vorzugsweise vorgesehen ist, daß der Spalt zwischen der Unterseite des Rahmens und der Kontaktkraftaufnahmevorrichtung derart vorgesehen ist, daß die Chipkarte in der Leseposition sicher gehalten ist, und/oder wobei vorzugsweise vorgesehen ist, daß im Bereich der Lesekontakte und/oder zwischen dem Lesekontakten und der Einstecköffnung des Chipkartenlesers ein runder Bolzen angeordnet ist, auf dem eine Elastomerrolle drehbar gelagert ist, und/oder wobei vorzugsweise vorgesehen ist, daß die durch die Kontaktaufnahmevorrichtung auf die Karte ausgeübte Kraft ausreicht, die Karte in der aktiven oder Leseposition verschleißfrei festzuhalten.
